(19) **Europäisches Patentamt**

**European Patent Office**

**Office européen des brevets**

(11) **EP 0 755 114 B1**

(12) **FASCICULE DE BREVET EUROPEEN**

(45) Date de publication et mention
de la délivrance du brevet:
**24.10.2001 Bulletin 2001/43**

(51) Int Cl.$^7$: **H03F 3/193**

(21) Numéro de dépôt: **96202008.7**

(22) Date de dépôt: **15.07.1996**

(54) **Dispositif semi-conducteur incluant un amplificateur de puissance et appareil terminal mobile de télécommunication incluant un tel dispositif semi-conducteur**

Halbleitervorrichtung mit einem Leistungsverstärker und mobilen Telekommunikationsendgerät mit einer solchen Halbleitervorrichtung

Semiconductor device comprising a power amplifier and mobile telecommunication terminal apparatus including such a semiconductor device

(84) Etats contractants désignés:
**DE FR GB**

(30) Priorité: **21.07.1995 FR 9508894**

(43) Date de publication de la demande:
**22.01.1997 Bulletin 1997/04**

(73) Titulaire: **Koninklijke Philips Electronics N.V.
5621 BA Eindhoven (NL)**

(72) Inventeurs:
 • **Leroux, Bruno
  75008 Paris (FR)**
 • **Meignant, Didier
  75008 Paris (FR)**
 • **Puechberty, Eric
  75008 Paris (FR)**

(74) Mandataire: **Lottin, Claudine et al
Société Civile S.P.I.D.
156, Boulevard Haussmann
75008 Paris (FR)**

(56) Documents cités:
 **EP-A- 0 074 294        EP-A- 0 596 562**

 • **GAAS IC SYMPOSIUM 15TH ANNUAL GAAS IC SYMPOSIUM TECHNICAL DIGEST 1993, 10 - 13 Octobre 1993, SAN JOSE, CA, pages 229-232, XP000462978 K. JOSHIN ET AL: "A HIGH-GAIN HEMT MONOLITHIC DOWNCONVERTER FOR X-BAND DIRECT BROADCAST SATELLITE APPLICATIONS"**
 • **1983 IEEE MTT-S INTERNATIONAL MICROWAVE SYMPOSIUM DIGEST, 31 Mai 1983 - 3 Juin 1983, BOSTON, MASSACHUSETTS, pages 69-73, XP002011771 K.P. WELLER ET AL: "GAAS MONOLITHIC LUMPED ELEMENT MULTISTAGE MICROWAVE AMPLIFIER"**

**Description**

L'invention concerne un dispositif semiconducteur incluant un circuit amplificateur de puissance comprenant une pluralité d'étages à transistors à effet de champ à désertion montés en série, dont des premiers étages et un dernier étage ; des bornes pour une tension de polarisation positive, pour la masse, et pour l'entrée et la sortie d'un signal alternatif de fonctionnement en hautes ou en hyperfréquences ; et des éléments de polarisation des transistors par la tension positive sur les drains, par une tension négative sur les grilles et par la connexion des sources communes à la borne de masse.

L'invention concerne aussi un appareil terminal mobile de télécommunication incluant un tel dispositif semiconducteur.

L'invention trouve son application dans la réalisation d'émetteurs-récepteurs mobiles dans la norme DECT (Digital European Cordless Telephon), qui est la norme européenne de téléphonie numérique sans fil, selon laquelle le dispositif travaille à 1,8 GHz en utilisant des multiplexages séquentiels et temporels.

Un circuit amplificateur est déjà connu de l'état de la technique par la demande de brevet européen EP 0596 562 A1. Ce document décrit un circuit amplificateur incluant deux étages à transistors à effet de champ, montés en série. Ces étages sont alimentés par une seule tension de polarisation continue positive disponible entre un plot d'alimentation et la masse. Ces étages nécessitent en outre une tension de polarisation négative sur leur grille par rapport à la masse.

Selon le document cité, un signal de forte puissance, dans le domaine des hautes ou hyperfréquences, est'appliqué à l'entrée du premier étage de l'amplificateur. Ce signal de forte puissance est constitué soit par le signal de fonctionnement du circuit amplificateur, soit par un signal auxiliaire provenant d'un générateur à une fréquence plus faible que la fréquence du signal de fonctionnement, appliqué en parallèle avec ce dernier sur l'entrée du premier étage du circuit amplificateur. Ce premier étage est un étage de puissance dont le transistor travaille dans sa région de saturation. Lorsque l'étage est alimenté par la tension de polarisation positive et en même temps reçoit le signal alternatif de puissance sur la grille de son transistor à effet de champ, il apparaît, sur la grille de ce transistor, un courant de fuite résultant en une tension négative de grille de l'ordre de -1V qui est disponible aux bornes d'une grande résistance de 10 kΩ placée entre cette grille et la masse. Cette tension négative de grille place ce transistor de l'étage d'entrée du circuit amplificateur dans les conditions de polarisation requise pour son fonctionnement.

La tension aux bornes de la grande résistance de grille du premier étage du circuit amplificateur est en outre prélevée pour polariser la grille du transistor du deuxième étage placé derrière le premier étage, en série.

Un problème technique existe à ce jour pour alimenter en continu les circuits semiconducteurs des petits systèmes portables. Dans ces systèmes, il est maintenant devenu impératif de n'utiliser qu'une seule tension de polarisation en continu positive fournie par une pile ou par une batterie de par exemple + 3V. Or, les transistors à effet de champ pour réaliser les circuits amplificateurs de puissance sont du type à désertion (depletion transistor, en anglais) c'est-à-dire normalement passant en l'absence de tension de polarisation grille-source (VGS = 0) (Normally-ON en anglais). Ces transistors nécessitent une tension de polarisation de grille comprise entre -1V et -3V pour obtenir leur fonctionnement. Cette tension de polarisation négative pour la grille des transistors à désertion doit être générée dans le dispositif semiconducteur. La génération de cette tension négative est un problème du fait qu'elle suppose la présence d'un étage supplémentaire dans le circuit ce qui a pour conséquences une surface de circuit plus grande et une consommation supplémentaire ; ces conséquences sont très néfastes dans le cadre de la fabrication de petits systèmes mobiles.

Un autre problème technique existe lorsque le circuit amplificateur à fabriquer comporte à partir de son entrée, plusieurs étages linéaires, c'est-à-dire ne pouvant pas travailler dans la région de saturation, parce que son premier étage reçoit un signal de fonctionnement à faible puissance, de l'ordre du mW. Dans ces conditions, la solution proposée par le document cité au titre d'état de la technique ne peut pas être utilisée sans l'aide d'un générateur auxiliaire, ce qui n'est pas possible dans le cadre de la fabrication de petits systèmes mobiles.

Un tel problème technique existe dans le cas particulier de la fabrication d'émetteurs-récepteurs dans la norme DECT. Ces systèmes comportent un amplificateur de puissance qui reçoit un signal alternatif de fonctionnement de faible puissance, environ 1 mW, et doit fournir en sortie un signal alternatif de forte puissance environ 0,5 W en hyperfréquences. En outre, les entrée et sortie de cet amplificateur, dans cette norme, sont soumises à un gabarit. Et il est impératif que les appareils munis de ces systèmes soient très légers, très peu encombrants, et aient une très faible consommation afin d'avoir une autonomie de fonctionnement la plus grande possible.

Un autre problème technique existe dans le cas particulier de la fabrication d'émetteurs-récepteurs dans la norme DECT. En effet, il est imposé que la tension d'alimentation en continu positive arrive sur le circuit après le signal alternatif de fonctionnement. Il est apparu par des essais que ces conditions créent un problème dans le cas où un amplificateur comportant un plus grand nombre d'étages que celui du document cité, est réalisé. Ce problème consiste en l'apparition d'un pic de courant sur le circuit de polarisation de drain des étages à transistor au moment de l'arrivée du signal d'alimentation continue positive sur le circuit amplificateur. Ce pic de courant est destructeur et non tolérable.

La présente invention propose un circuit amplificateur ayant une pluralité d'étages en série, c'est-à-dire plus de 2 étages pour fournir à partir d'un signal d'entrée de faible puissance, typiquement 1 mW, un signal de sortie de forte puissance typiquement 0,5 W, ce circuit amplificateur comportant l'utilisation d'une seule tension de polarisation positive externe, comportant la génération des tensions de polarisation négative de grille sans ajout d'un étage préliminaire de puissance ou sans ajout d'un générateur auxiliaire.

La présente invention propose en outre un tel circuit dans lequel il n'existe pas de pic de courant parasite lors de l'application de la tension d'alimentation positive externe.

La présente invention propose un tel circuit amplificateur qui répond aux conditions de la norme DECT.

Ces buts sont atteints au moyen d'un dispositif semiconducteur incluant un circuit amplificateur de puissance tel que revendiqué à la revendication 1.

Un tel dispositif semiconducteur présente entre autres les avantages :

de ne pas nécessiter de tension de polarisation négative externe ;

de ne pas nécessiter d'étage spécifique supplémentaire pour générer la tension de polarisation négative ;

de répondre à une condition de la norme de télécommunication DECT selon laquelle l'amplificateur doit recevoir un petit signal d'1 mW à 0 dB.m sur 50 $\Omega$ et fournir un signal amplifié en puissance, de 0.5 W à 27 dB.M sur 50 $\Omega$;

de répondre à une autre condition de la norme DECT selon laquelle la tension de polarisation continue positive est imposée à un instant postérieur à l'instant où le signal alternatif de fonctionnement est imposé à la borne d'entrée du circuit amplificateur ;

de répondre d'une manière générale à la condition de la norme DECT selon laquelle la puissance des signaux est soumise à un gabarit ;

de ne pas produire de pic de courant parasite lors de l'imposition de la tension de polarisation positive ;

de montrer une consommation minimale, et de montrer, dans son dernier étage de puissance, le plus fortement sensible à la consommation, un rendement maximal.

L'invention est décrite ci-après en détail, en référence avec les figures schématiques annexées, dont :

-    la FIG.1 qui représente un circuit amplificateur de puissance PA ;
-    la FIG.2A qui représente l'avant-dernier étage et le dernier étage du circuit amplificateur PA ;
-    la FIG.2B qui représente un schéma équivalent des deux étages de la FIG.2A ;
-    la FIG.3 qui représente un système mobile de télécommunication incluant un circuit amplificateur tel que celui de la FIG.1.

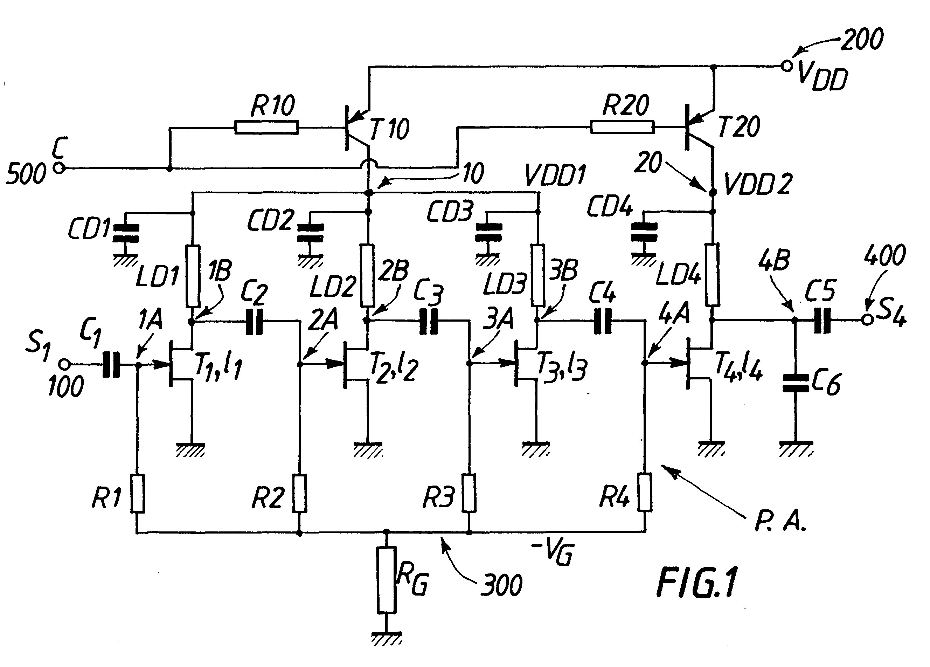

En référence avec la FIG.1, un circuit amplificateur PA comprend d'abord une entrée 100 pour un signal alternatif.

Un tel circuit amplificateur de puissance PA, pour appareil mobile selon la norme DECT, reçoit sur son entrée 100 un signal S1 alternatif dans le domaine des hautes fréquences ou des hyperfréquences typiquement à 0,9 GHz ou 1,8 GHz. Ce signal alternatif S1 a une petite amplitude de 0,7 V crête à crête, imposée par la norme DECT, sur 50 Q, soit une puissance de 0 dB.m à son entrée 100.

Ce circuit amplificateur comprend d'une part plusieurs étages à transistors à effet de champ, montés en série, appelés premiers étages, et d'autre part un dernier étage à transistor à effet de champ monté en série avec les premiers étages.

Cet amplificateur de puissance doit fournir, selon la norme DECT, un signal de sortie S4 sur le drain du dernier transistor à effet de champ, avec une puissance de 27 dB.m, sur 50 $\Omega$ soit 500 mW (0,5 W).

Ce circuit amplificateur comporte en outre une borne 200 pour l'application d'une tension de polarisation continue positive VDD, de par exemple +3 V, et une borne de masse.

De plus, selon la norme DECT, la puissance du signal dans le circuit amplificateur doit rester conforme à un gabarit qui impose que le signal alternatif d'entrée S1 soit appliqué à la borne d'entrée 100 du circuit amplificateur à un instant antérieur à l'instant où la tension de polarisation positive + VDD est appliquée à la borne 200.

Le circuit amplificateur PA selon l'invention comporte non seulement des moyens pour fournir un signal de sortie S4, disponible sur sa borne de sortie 400, qui soit conforme au gabarit de la norme DECT, mais encore ce circuit amplificateur PA comporte des moyens pour générer de manière interne une tension de polarisation négative nécessaire à son fonctionnement.

En référence avec la FIG.1, le circuit amplificateur PA comporte d'abord à partir de son entrée 100, au moins 2, et de préférence 3 étages amplificateurs en série comprenant des transistors à effet de champ du type MESFET, à barrière Schottky, à désertion. Ces transistors nécessitent pour leur fonctionnement une tension de polarisation de grille négative de l'ordre de -1,5 V.

Le dernier étage est constitué de la même manière que les premiers étages.

Le premier étage du circuit amplificateur comprend un transistor T1, de largeur de grille 11, dont le drain 1B est connecté à la borne de polarisation positive VDD par une charge LD1, et dont la source est connectée directement à la masse. Sa grille reçoit le signal alternatif S1 au noeud 1A, à travers une capacité C1, et fournit un signal alternatif au noeud 1B sur son drain, amplifié en tension et en puissance.

Le deuxième étage du circuit amplificateur PA comprend un transistor T2, de largeur de grille 12, dont le drain 2B est connecté à la borne de polarisation positive VDD par une charge LD2, et dont la source est connectée directement à la masse. Sa grille reçoit le signal alternatif déjà amplifié, au noeud 2A, à travers une capacité C2, et fournit un signal alternatif au noeud 2B sur son drain, ce signal étant encore amplifié en tension et en puissance.

Le troisième étage du circuit amplificateur comprend un transistor T3, de largeur de grille 13, dont le drain 3B est connecté à la borne de polarisation positive VDD par une charge LD3, et dont la source est connectée directement à la masse. Sa grille reçoit le signal alternatif amplifié par le second étage, au noeud 3A, à travers une capacité C3, et fournit un signal alternatif toujours amplifié en tension et en puissance au noeud 3B.

Chaque étage à transistor est isolé en continu par une capacité disposée entre le drain du transistor de l'étage précédent et la grille du transistor de l'étage suivant.

Ainsi, les capacités C1, C2, C3, C4 isolent respectivement, en continu le premier, le deuxième, le troisième, et le quatrième étage qui est aussi le dernier étage dans l'exemple de circuit amplificateur représenté sur la FIG.1.

Ce quatrième étage du circuit amplificateur PA comprend un transistor T4, de largeur de grille 14, dont le drain 4B est connecté à la borne de polarisation positive VDD par une charge LD4, et dont la source est connectée directement à la masse. Sa grille reçoit le signal alternatif amplifié par le troisième étage, au noeud 4A, à travers la capacité C4.

Le transistor T4 du quatrième étage est un transistor de puissance de forte largeur de grille 14, car le signal alternatif qu'il reçoit est déjà très fortement amplifié en tension et en puissance.

Ce quatrième étage fournit sur son drain le signal alternatif de sortie S4 avec les niveaux de tension et de puissance imposée par la norme DECT.

Les moyens pour générer en interne une tension de polarisation négative VG sur les grilles de tous les transistors MESFET à désertion de T1 à T4 compris, prennent en compte l'existence d'une diode intrinsèque grille-source symbolisée par une flèche sur les grilles des transistors représentés de manière symbolique sur la FIG.1 et utilise la fonction rectificatrice de cette diode. Dans ces MESFETS à désertion, cette diode grille-source a un seuil de conduction de l'ordre de 0,7V, et montre une fonction rectificatrice lorsque la tension alternative positive qui lui est appliquée est supérieure à ce seuil de 0,7V.

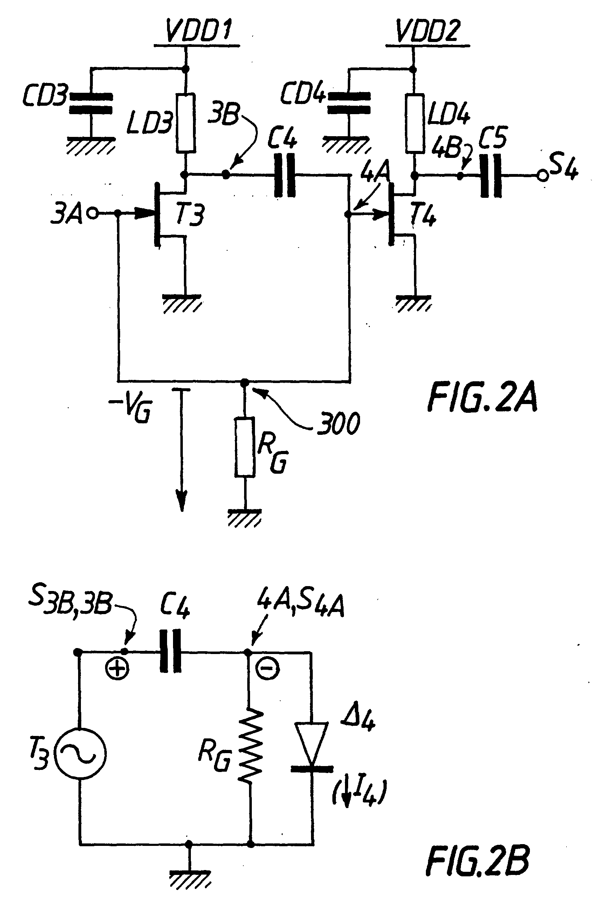

En référence avec la FIG.2A qui montre isolément l'avant-dernier ou troisième, et le dernier ou quatrième étage du circuit amplificateur PA de la FIG.1, il faut prendre en compte que le signal alternatif amplifié a maintenant au noeud 3B sur le drain du transistor T3 une amplitude en tension crête-à-crête de l'ordre de 4,4 volts, en supposant que l'on avait à l'origine le signal S1 à l'entrée 100, de caractéristiques conformes à la norme DECT.

A un premier instant to où arrive pour la première fois sur le drain 3B du transistor T3, un signal alternatif noté S3B, ce signal S3B est transmis immédiatement au noeud 4A, à travers la capacité C4 d'isolation en continu entre étages. A ce premier instant to, il n'y a pas de différence de potentiel aux bornes 3B, 4A de la capacité C4, et cette capacité C4 n'est pas chargée.

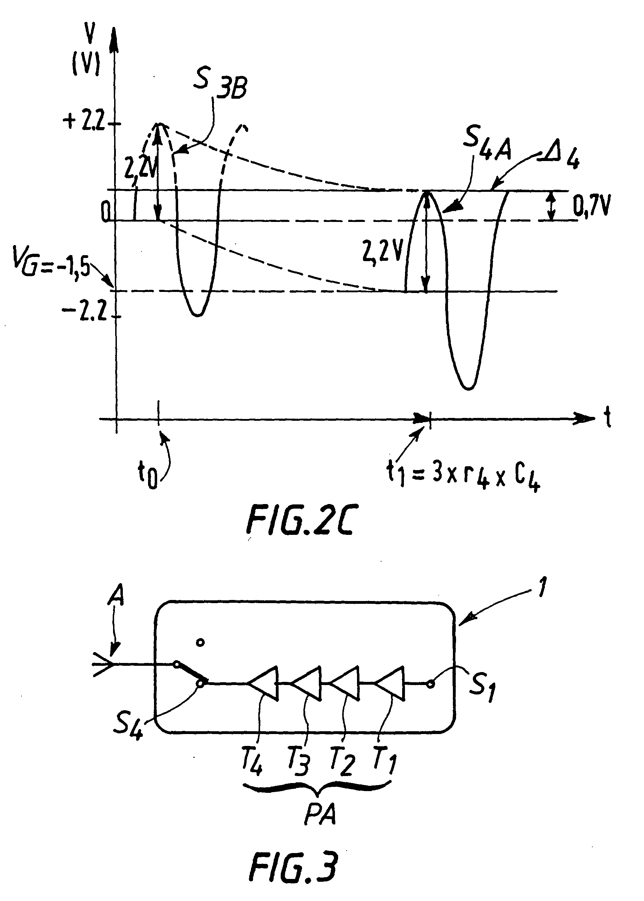

En référence avec la FIG.2B qui montre un circuit équivalent à ces étages, et avec la FIG.3C qui est un chronogramme représentant l'évolution des tensions continues et alternatives au noeud 4A, sur la grille du transistor du dernier étage, il vient que :

- la tension alternative maintenant notée S4A se trouvant à l'instant to, au noeud 4A, sur la grille du transistor T4, a la même amplitude que le signal S3B c'est-à-dire crête-à-crête, de l'ordre de 4,4V centrée sur le niveau 0V continu. Cette amplitude a une partie positive de +2,2 V entre le niveau 0V et la crête positive du signal, et aussi une partie négative sous le niveau 0V. Seule compte la partie positive.
- cette tension alternative S4B dont la partie positive est de l'ordre de +2,2V se trouve appliquée sur la diode $\Delta4$ intrinsèque du dernier transistor T4. La partie positive de cette tension alternative a une amplitude qui dépasse la tension de seuil de la diode $\Delta4$, cette tension de seuil étant de l'ordre de 0,7V. Donc ce signal alternatif est tronqué.
- Dans ces conditions, la diode $\Delta4$ devient conductrice, et il en résulte un courant I4 qui s'établit, dans le circuit formé par les deux derniers étages à transistors T3 et T4, par la masse. Ce courant 14 n'est créé que par la partie positive du signal alternatif qui dépasse le seuil de 0,7V.

En référence avec le schéma équivalent de la FIG.2B, le transistor T3 est symbolisé par un générateur de tension, et le transistor T4 est symbolisé par sa diode $\Delta4$ intrinsèque.

Dès l'instant to où le signal alternatif S4A arrive au noeud 4A, la diode $\Delta4$ devient conductrice, la capacité d'isolation C4 commence à se charger, et une différence de potentiel apparaît à ses bornes, entre les noeuds 3B et 4A. Cette différence de potentiel est due uniquement à la tension du signal alternatif et non pas à la polarisation de drain du transistor T4, puisque C4 empêche la propagation de la tension de polarisation continue de drain.

Seule compte l'amplitude du signal alternatif, car seul le signal alternatif peut se propager à travers C4.

Ce régime de charge de la capacité C4 est un régime transitoire qui tend à faire baisser le niveau supérieur, +2,2V, de la crête du signal alternatif au noeud 4A, et donc à faire baisser son niveau moyen qui était 0V, à l'instant to. L'amplitude crête à crête du signal est inchangée. Seul son niveau moyen baisse.

Ce régime transitoire de charge de la capacité se maintient jusqu'à ce que la diode Δ4 ne conduise plus et donc que le courant de charge 14 n'existe plus. La capacité C4 est maintenant, à ce nouvel instant t1, totalement chargée. Puisque la diode Δ4 ne conduit plus et que le courant I4 est redevenu nul, l'état du circuit est alors dit stationnaire.

Le régime stationnaire apparaît en général à un instant t1 séparé de l'instant initial to par un délai de temps

$$t1 - t0 = 3\tau = 3 \times r4 \times C4$$

où $\tau$ est la constante de temps du système formé par la capacité C4 et par la résistance r4 interne de la diode Δ4. Ces valeurs sont de l'ordre de :

$r^4$ _ 0,1 Ω
C4 _ 10 pF
$3\tau$ _ $3.10^{-12}$ sec.

Le régime transitoire est donc très court. Le circuit R-C formé de la résistance de la diode intrinsèque Δ4 et de la capacité d'isolation entre étage C4 est appelé circuit redresseur série.

En référence avec le chronogramme de la FIG.2C, à l'instant t1 dans l'état stationnaire, la crête positive du signal alternatif au noeud 4A ne dépasse plus les 0,7V de seuil de conduction de la diode Δ4. Le signal n'est plus tronqué. Le signal alternatif S4A a une amplitude crête à crête de 4,4V, comme le signal alternatif S3B au noeud 3B mais son niveau moyen est décalé, et est maintenant positionné à -1,5V, précisément pour que la crête positive à +2,2V du signal soit positionnée entre ce niveau -1,5V et le niveau +0,7V du seuil de conduction de la diode Δ4.

Dans le régime stationnaire qui apparaît dès l'instant t1, le niveau de tension moyen au noeud 4A sur la grille du transistor T4 est -1,5V afin que la crête positive ne dépasse pas les 0,7V qui rendrait la diode Δ4 conductrice ; la différence de potentiel aux bornes de la capacité C4 est -1,5V avec les polarités indiquées sur la FIG.2B.

D'abord ce niveau de tension négative est extrêmement favorable à la polarisation de grille du dernier transistor T4.

Ensuite, comme montré sur le schéma équivalent de la FIG.2B, ce niveau moyen constitue une différence de potentiel continue disponible aux bornes d'une résistance de grande valeur RG disposée entre le noeud 4A, sur la grille du transistor T4, et la masse, avec la valeur négative -VG sur cette grille.

Dans le circuit schématique des deux derniers étages à transistors T3 et T4 de la FIG.2A, cette résistance RG est disposée entre le noeud 4A de grille du dernier transistor T4 et la masse, et la grille 3A de l'avant-dernier transistor T3 est reliée à la grille du dernier transistor pour se voir appliquer également cette tension négative -VG de l'ordre de -1,5V.

En référence avec la FIG.1, de préférence des petites résistances respectivement R1, R2, R2, R4 sont appliquées entre les grilles 1A, 2A, 3A, 4A et l'extrémité commune 300 de la grande résistance RG. Par le choix appropriée de ces petites résistances, l'homme du métier peut régler la consommation de chaque étage pour rendre cette consommation minimale.

En effet, ce circuit amplificateur PA destiné à un système portable doit consommer le moins possible pour que la batterie ou pile du système portable ait une durée de vie aussi longue que possible.

On donne ci-après des valeurs exemplatives d'éléments actifs et passifs permettant de réaliser le circuit amplificateur PA sous la forme d'un circuit semiconducteur intégré, le substrat pour réaliser ce circuit étant en arséniure de gallium, matériau favorable à l'intégration des circuits hautes et hyperfréquences. La puce formée par le circuit intégré sur ce substrat est disposée sur un support ou base.

l1 = 0,2 mm     l2 = 0,6 mm     l3 = 2 mm     l4 = 7 mm

R1 = 1 kΩ     R2 = 1 kΩ     R3 = 500 Ω     R4 = 1,2 kΩ

Dans ces 4 étages à transistors, favorablement les largeurs de grille des transistors sont croissantes de T1 à T4, les charges des transistors sont des selfs inductances, réalisées par exemple par les fils de connexion entre la puce formée par le substrat en arséniure de gallium et les plots de contact ou autres connexions réalisés sur le support. Pour une meilleure stabilité de l'amplificateur, il est en outre souhaitable de découpler séparément, par rapport à la masse au moyen d'une capacité, respectivement CD1, CD2, CD3, CD4, chacun des drains des transistors. Favorablement aussi mais non obligatoirement, le dernier étage à transistor, qui est le quatrième dans l'exemple de la FIG. 1, fonctionne en régime de saturation. On notera que ce n'est pas cette caractéristique qui induit la tension négative de grille, mais les moyens décrits plus haut. Le fonctionnement du dernier étage en régime saturé permet simplement d'améliorer le rendement de l'amplificateur (on rappelle que le rendement est donné par la formulation de la différence entre la puissance de sortie en alternatif et la puissance d'entrée en alternatif divisée par la puissance en continu).

Dans le circuit amplificateur tel que décrit plus haut en référence avec la FIG.1, du fait que d'une part, selon la norme DECT l'alimentation VDD en continu est imposée par un système de contrôle C après l'arrivée du signal alternatif S1 au noeud 100, et d'autre part du fait que toutes les grilles des transistors sont reliées, il peut apparaître au moment de l'application de cette tension d'alimentation continue positive VDD, un pic de courant de l'ordre de 2A, alors que le courant continu doit typiquement être de l'ordre de 500 mA.

Selon l'invention, la solution à ce problème est apportée par le circuit de commutation formé de deux transistors T10 et T20 de type MOS PNP, montés en parallèle et munis chacun d'une résistance sur leur base, respectivement R10 et R20. Les bases de ces transistors sont commandées, au même instant, par le signal de contrôle C appliqué à la borne 500. La tension continue VDD d'environ +3V est appliquée sur les émetteurs de ces transistors T10 et T20.

Le collecteur du transistor T10, distribue au noeud 10, la tension de polarisation de drain des 3 premiers étages du circuit amplificateur PA ; le collecteur du transistor T20 distribue au noeud 20, la tension de polarisation de drain du dernier étage à transistor de ce circuit amplificateur.

En choisissant des valeurs de résistance différentes et appropriées pour R10 et R20, par exemple

$$R20 = 500 \ \Omega$$

$$R10 = 1 \ k\Omega$$

on obtient la suppression du pic de courant.

En effet, au moment de l'application de la tension d'alimentation VDD sur l'amplificateur sous contrôle C, seul 'étage d'entrée du circuit amplificateur reçoit déjà le signal alternatif ; les grilles des autres étages sont encore au potentiel zéro ; l'application de la tension d'alimentation positive sur les transistors en court-circuit entraîne l'apparition d'un courant de saturation IDSS sur les drains. Si tous les drains de tous les étages sont alimentés par la même ligne de distribution en continu, l'impédance correspondant à tous les transistors groupés est grande et le courant de drain à saturation résultant est très grand, de l'ordre de 2A sous forme d'un pic de courant sur la ligne de distribution pendant quelques microsecondes.

Maintenant selon l'invention les lignes de distribution sont décorrélées, soit VDD1 pour les premiers étages et VDD2 pour le dernier étage, et sont alimentées par deux réseaux séparés R10, T10 et R20, T20 respectivement. Il en résulte que le pic de courant correspondant au courant de drain à saturation pour les 3 premiers étages groupés est de l'ordre de 100 mA ; et le pic de courant correspondant pour le dernier étage est de l'ordre de 400 mA.

Le réseau de commutation de la tension d'alimentation VDD résout donc ce problème de pic de courant dans le cas où tous les étages sont connectés par leur grille de la manière décrite plus haut appropriée à générer la tension négative de grille en interne.

En référence avec la FIG.3, le circuit amplificateur PA intégré et son réseau de commutation d'alimentation sont inclus dans un appareil terminal de télécommunication 1 portable et sans fil, c'est-à-dire mobile, comportant d'autres circuits intégrés, non décrits ici, et une antenne A. Cet appareil permet de recevoir et de transmettre.

Ce type d'appareil mobile est particulièrement approprié aux applications résidentielles, professionnelles ou non. Ce type d'appareil mobile suppose l'existence d'une base qui gère l'utilisation de plusieurs appareils mobiles par plusieurs utilisateurs séparés.

**Revendications**

1. Dispositif semiconducteur incluant un circuit amplificateur de puissance comprenant :

   une   pluralité d'étages à transistors à effet de champ à désertion, montés en série, dont des premiers étages et un dernier étage, montés en série (T1, T2, T3, T4),

des bornes pour une tension de polarisation positive (VDD), pour la masse, et pour l'entrée (S1) et la sortie (S4) d'un signal alternatif de fonctionnement en hautes ou en hyper fréquences,

des éléments de polarisation des transistors par la tension positive sur les drains, par une tension négative sur les grilles, et par la connexion des sources communes à la borne de masse,

circuit amplificateur dans lequel :

les éléments de polarisation desdits premiers étages sont arrangés pour fournir sur le drain (3B) du dernier (T3) des premiers étages un signal alternatif amplifié en tension, dont l'amplitude de sa partie positive est supérieure au seuil de conduction de la diode intrinsèque du transistor (T4) du dernier étage,

le transistor du dernier étage est isolé du dernier desdits premiers étages par une capacité d'isolement en continu (C4) d'une valeur appropriée pour former, avec la résistance (r) de la diode intrinsèque du transistor dudit dernier étage, un circuit de type R-C redresseur-série, dans lequel ledit circuit redresseur-série (r-C4) impose sur la borne de ladite capacité d'isolation (C4), commune à la grille du transistor (T4) dudit dernier étage, un décalage du niveau moyen du signal alternatif par rapport à la valeur de ce niveau moyen sur l'autre borne de ladite capacité, ledit décalage étant utilisé comme une tension négative, disponible aux bornes d'une résistance (RG) disposée entre la grille (4A) dudit dernier transistor et la masse, et dans lequel toutes les grilles des transistors des étages (T1, T2, T3) précédant le dernier étage (T4) sont connectées à la grille du transistor du dernier étage, ladite tension négative étant utilisée comme tension de polarisation desdites grilles des étages précédents.

2. Dispositif selon la revendication 1, dans lequel, entre chaque grille des transistors de tous les étages et leur point de connexion, sont interposées respectivement des résistances.

3. Dispositif selon l'une des revendications 1 ou 2, dans lequel le nombre des premiers étages est trois, et le dernier étage est le quatrième étage.

4. Dispositif selon l'une des revendications 1 à 3, comprenant en outre un réseau de commutation de la tension de polarisation positive comprenant deux étages à transistors, commandés par un même signal de contrôle et munis respectivement d'une charge, pour alimenter séparément une première ligne de distribution de la tension de polarisation positive pour lesdits premiers étages, et une deuxième ligne de distribution de la tension de polarisation positive pour ledit dernier étage.

5. Dispositif selon la revendication 4, dans lequel les transistors des réseaux de commutation sont du type MOS PNP, le signal de contrôle est appliqué simultanément sur leur base à travers lesdites charges respectivement formées de résistances, la tension de polarisation positive est appliquée sur leurs émetteurs, et leurs collecteurs sont connectés respectivement aux première et seconde lignes de distribution.

6. Système de télécommunication mobile comprenant un dispositif semiconducteur incluant un circuit amplificateur de puissance selon l'une des revendications 1 à 5.

## Claims

1. A semiconductor device including a power amplifier circuit which comprises:

a plurality of series-arranged depletion-layer field effect transistor stages, among which first stages and a last stage (T1, T2, T3, T4);
terminals for a positive bias voltage (VDD), for ground, and for the input (S1) and output (S4) of a high or very high frequency AC signal,
bias elements for biasing transistors via the positive voltage on the drains, via a negative voltage on the gates and via the connection of the common sources to the ground terminal,

in which amplifier circuit

the bias elements of said first stages are arranged for producing on the drain (3B) of the last one (T3) of the first stages a voltage amplified AC signal of which the amplitude of its positive component is higher than the conduction threshold of the intrinsic diode of the transistor (T4) of the last stage,

the transistor of the last stage is isolated from the last one of said first stages by a D.C. isolation capacitor (C4) which forms, together with the resistor (r) of the intrinsic diode of the transistor of said last stage, a series-arranged R-C rectifier circuit, which series-arranged rectifier circuit (r-C4) imposes on the terminal of said isolation capacitor (C4) common to the gate of the transistor (T4) of said last stage a shift of the mean level of the AC signal relative to the value of this mean level on the other terminal of said capacitor, said shift being used as a negative voltage which is available on the terminals of a resistor (RG) inserted between the gate (4A) of said last transistor and ground, and in which all the gates of the transistors of the stages (T1, T2, T3) preceding the last stage (T4) are connected to the gate of the transistor of the last stage, said negative voltage being used as a bias voltage of said gates of the preceding stages.

2. A device as claimed in claim 1, in which resistors are inserted between each gate of the transistors of all the stages and their connection point.

3. A device as claimed in one of the claims 1 or 2, in which the number of first stages is three and the last stage is the fourth stage.

4. A device as claimed in one of the claims 1 to 3, further including a switching network for switching the positive bias voltage, which comprises two transistor stages, controlled by the same control signal and fed by a load for separately feeding a first positive bias voltage distribution line for said first stages, and a second positive bias voltage distribution line for said last stage.

5. A device as claimed in claim 4 in which the transistors of the switching networks are of the MOS PNP type, the control signal is simultaneously applied to their base through said loads formed by resistors, the positive bias voltage being applied to their emitters and their collectors are connected to the first and second distribution line, respectively.

6. A mobile telecommunication system comprising a semiconductor device that includes a power amplifier circuit as claimed in one of the claims 1 to 5.

**Patentansprüche**

1. Halbleitervorrichtung mit einem Leistungsverstärker mit:
   einer Vielzahl in Serie geschalteter Verarmungs-Feldeffekt-Transistorstufen,

   worunter erste Stufen und eine letzte Stufe (T1, T2, T3, T4), Klemmen für eine positive Polarisierungsspannung (VDD), für die Masse und für
   den Eingang (S1) und den Ausgang (S4) eines Wechselstrom-Betriebssignals in Hoch- oder Hyperfrequenzen,
   Polarisierungselemente der Transistoren über die positive Spannung über Drains,
   über eine negative Spannung über Gates und über den Anschluß gemeinsamer Sources an die Masseklemme,

   Verstärkerschaltung, in der:
   die Polarisierungselemente der besagten ersten Stufen angeordnet sind, um am Drain (3B) der letzten (T3) der ersten Stufen ein spannungsverstärktes Wechselstromsignal zu liefern, dessen Amplitude seines positiven Teils über der Leitschwelle der internen Diode des Transistors (T4) der letzten Stufe liegt,
   der Transistor der letzten Stufe von der letzten der besagten ersten Stufen über eine Gleichstrom-Isolierkapazität (C4) eines geeigneten Wertes getrennt ist, um mit dem Widerstand (r) der internen Diode des Transistors der besagten letzten Stufe einen Serien-Gleichrichter-Schaltungstyp R-C zu bilden, in dem die besagte Serien-Gleichrichterschaltung (r-C4) der Klemme der besagten Isolationskapazität (C4), gemein mit dem Gate des Transistors (T4) der besagten letzten Stufe, eine Versetzung des mittleren Niveaus des Wechselstromsignals in bezug auf den Wert dieses mittleren Niveaus an der anderen Klemme der besagten Kapazität vorgibt, wobei die besagte Versetzung als negative Spannung verwendet wird, verfügbar an den Klemmen eines Widerstands (RG), zwischen dem Gate (4A) des besagten letzten Transistors und der Masse angeordnet, und wobei sämtliche Gates der der letzten Transistorstufe (T4) vorausgehenden Transistorstufen (T1, T2, T3) an das Gate der letzten Stufe angeschlossen sind, und die besagte negative Spannung als Polarisationsspannung der besagten Gates der vorhergehenden Stufen verwendet wird.

2. Vorrichtung nach Anspruch 1, in der zwischen jedes Gate der Transistoren aller Stufen und ihren respektiven Verbindungspunkt Widerstände zwischengeschaltet sind.

3. Vorrichtung nach einem der Ansprüche 1 oder 2, in dem die Anzahl der ersten Stufen drei beträgt, und die letzte Stufe die vierte Stufe ist.

4. Vorrichtung nach einem der Ansprüche 1 bis 3, mit zudem einem Netz zur Schaltung der positiven Polarisierungsspannung aus zwei Transistorstufen, gesteuert von einem selben Kontrollsignal und respektive mit einer Ladung versehen, um eine erste Versorgungsleitung der positiven Polarisierungsspannung für die besagten ersten Stufen, und eine zweite Versorgungsleitung der positiven Polarisierungsspannung für die besagte letzte Stufe zu versorgen.

5. Vorrichtung nach Anspruch 4, in der die Transistoren der Schaltnetze vom Typ MOS PNP sind, das Kontrollsignal simultan ihrer Basis über die besagten respektiven, aus Widerständen gebildeten Ladungen zugeführt wird, die positive Polarisierungsspannung ihren Emittern zugeführt wird und ihre Kollektoren respektive an die erste und zweite Versorgungsleitung angeschlossen sind.

6. Mobiles Telekommunikationssytem mit einer Halbleitervorrichtung aus einer Leistungsverstärkerschatlung nach einem der Ansprüche 1 bis 5.

FIG.1

EP 0 755 114 B1

FIG.2A

FIG.2B

**FIG.2C**

**FIG.3**